# FASCICULE DE BREVET EUROPEEN

(11) **EP 1 880 387 B1**
(45) Date de publication et mention de la délivrance du brevet: **26.11.2008**
(21) Numéro de dépôt: 06726154.5
(22) Date de dépôt: 31.03.2006
(51) Int. Cl.: G11C 7/24, G11C 16/22

(54) **DISPOSITIF DE PROTECTION D'UNE MEMOIRE CONTRE LES ATTAQUES PAR INJECTION D'ERREUR**
EINRICHTUNG ZUM SCHUTZ EINES SPEICHERS VOR FEHLERINJEKTIONSATTACKEN
DEVICE FOR PROTECTING A MEMORY AGAINST FAULT-INJECTION ATTACKS

(30) Priorité: 09.05.2005 FR 0504610
(43) Date de publication de la demande: 23.01.2008
(73) Titulaire: STMicroelectronics SA, F-92120 Montrouge (FR)
(72) Inventeur: WUIDART, Sylvie, F-83910 Pourrières (FR)
(74) Mandataire: Marchand, André
(86) Numéro de dépôt international: PCT/FR2006/000704
(87) Numéro de publication internationale: WO 2006/120310

(56) Documents cités:
- EP-A- 1 150 300
- WO-A-00/72117
- US-A- 6 160 734
- US-A1- 2004 052 110

## Description

La présente invention concerne la protection des circuits intégrés contre les attaques par injection d'erreur, et notamment la protection des circuits intégrés présents dans les cartes à puce.

La présente invention concerne plus particulièrement un procédé pour sécuriser la lecture d'une mémoire.

Elle s'applique notamment, mais non exclusivement aux mémoires non volatiles telles que les mémoires ROM, EEPROM et FLASH.

Ces dernières années, les techniques de piratage des circuits intégrés sécurisés à microprocesseur (microprocesseurs, microcontrôleurs, mémoires à microprocesseur, circuits intégrés à coprocesseurs...) ont considérablement évolué. A l'heure actuelle, les méthodes de piratage les plus avancées consistent à injecter des erreurs en des points déterminés d'un circuit intégré lors de l'exécution d'opérations dites sensibles, par exemple des opérations d'authentification ou des opérations d'exécution d'un algorithme de cryptographie. De telles attaques par injection d'erreur, appelées également attaques par injection de faute, permettent, en combinaison avec des modèles mathématiques, de déduire la structure d'un algorithme de cryptographie à logique câblée et/ou les clefs secrètes qu'il utilise. L'injection d'erreur peut être faite de diverses manières, en introduisant des perturbations ("glitches") dans la tension d'alimentation du circuit intégré, en introduisant des perturbations dans le signal d'horloge du circuit intégré, en exposant le circuit intégré à des radiations ou un faisceau laser, etc.

D'après le document US 2004/052110, il est connu de procéder à des vérifications d'intégrité du contenu de la mémoire, par exemple au démarrage du circuit intégré ou durant le fonctionnement de celui-ci. Toutefois, ces vérifications ne permettent pas de détecter des attaques qui ne modifient pas le contenu de la mémoire, mais qui visent à modifier les données au moment où elles sont lues dans la mémoire, c'est-à-dire sur le chemin de lecture de la mémoire.

La présente invention a pour but de protéger une mémoire contre des attaques visant à modifier une donnée durant le cycle de lecture. Cet objectif est atteint en prévoyant à chaque lecture de la mémoire une seconde lecture d'une donnée de référence dont l'intégrité est vérifiée.

Plus particulièrement, l'invention prévoit un procédé de lecture d'une donnée dans une mémoire, comportant un cycle de lecture d'une donnée dans la mémoire, déclenché à la suite de la réception d'un ordre de lecture par la mémoire, et comprenant une étape de lecture de la donnée dans la mémoire. Selon l'invention, le cycle de lecture d'une donnée dans la mémoire comprend en outre des étapes consistant à :
- lire une donnée de référence stockée dans la mémoire,
- comparer la donnée de référence lue avec une valeur attendue, et
- signaler une erreur de lecture si la donnée de référence lue est différente de la valeur attendue.

Selon un mode de réalisation de l'invention, la lecture de la donnée de référence est effectuée immédiatement après la lecture de la donnée à lire dans la mémoire.

Selon un mode de réalisation de l'invention, la lecture de la donnée de référence est effectuée au cours d'un cycle d'horloge suivant la lecture de la donnée à lire dans la mémoire.

Selon un mode de réalisation de l'invention, la lecture de la donnée de référence est effectuée au cours d'un même cycle d'horloge que la lecture de la donnée à lire dans la mémoire.

Selon un mode de réalisation de l'invention, la mémoire comprend des cellules mémoire connectées à des lignes de mot agencées en lignes, et à des lignes de bit agencées en colonnes de bits, les lignes de mot étant connectées à un décodeur de ligne, les lignes de bit étant reliées à des amplificateurs de lecture, la phase de lecture d'une donnée dans la mémoire comprenant des étapes consistant à :
- sélectionner une ligne de mot correspondant à une adresse reçue de la donnée à lire,
- lire des cellules mémoires de la ligne de mot sélectionnée,
- appliquer le contenu des cellules mémoire lues sur un bus de données de sortie de la mémoire,
- sélectionner une ligne de mot de référence correspondant à l'adresse de la donnée de référence,
- lire des cellules mémoire de référence de la ligne de mot de référence sélectionnée, dans lesquelles la donnée de référence est mémorisée,
- comparer la donnée de référence lue à une valeur attendue, et
- placer la mémoire dans un mode d'erreur si la donnée de référence lue est différente de la valeur attendue.

Selon un mode de réalisation de l'invention, la mémoire émet un signal d'erreur en mode d'erreur.

L'invention concerne également une mémoire sécurisée en lecture comprenant des moyens pour lire une donnée dans la mémoire durant un cycle de lecture, en réponse à une commande de lecture de la donnée reçue par la mémoire. Selon l'invention, la mémoire comprend :
- des moyens pour lire dans la mémoire durant le cycle de lecture une donnée de référence, en réponse à la commande de lecture de la donnée ,
- des moyens pour comparer la donnée de référence lue avec une valeur attendue, et
- des moyens pour générer un signal d'erreur si la donnée de référence lue est différente de la valeur attendue.

Selon un mode de réalisation de l'invention, la lecture de la donnée et de la donnée de référence est effectuée durant un même cycle d'horloge.

Selon un mode de réalisation de l'invention, la lecture de la donnée et de la donnée de référence est effectuée durant deux cycles d'horloge successifs.

Selon un mode de réalisation de l'invention, la mémoire comprend :
- des cellules mémoire connectées à des lignes de mot agencées en lignes et à des lignes de bit agencées en colonnes de bits,
- un décodeur de ligne connecté aux lignes de mot pour sélectionner durant le cycle de lecture une ligne de mot correspondant à une adresse reçue de la donnée à lire,
- des moyens pour sélectionner durant le cycle de lecture d'un mot dans la mémoire, une ligne de mot de référence à laquelle sont connectées des cellules mémoire de référence contenant la donnée de référence, et pour déclencher la lecture des cellules mémoire de référence sélectionnées, et
- des moyens pour comparer le contenu des cellules mémoire de référence lues à des valeurs attendues respectives, le signal d'erreur étant émis sur une sortie de signal d'erreur si le contenu d'une cellule mémoire de la ligne de mot de référence est différente d'une valeur attendue respective.

Selon un mode de réalisation de l'invention, les cellules mémoires sont disposées dans un plan mémoire, la ligne de mot de référence étant située sur un bord du plan mémoire à l'opposé de liaisons des lignes de bit avec des amplificateurs de lecture.

Selon un mode de réalisation de l'invention, un décodeur de colonne pour sélectionner un groupe de lignes de bit formant un mot correspondant à l'adresse reçue de la donnée à lire, les cellules mémoire de la ligne de mot de référence dans laquelle la donnée de référence est stockée, mémorisant la donnée de référence dans chaque groupe de lignes de bit.

Ces objets, caractéristiques et avantages ainsi que d'autres de la présente invention seront exposés plus en détail dans la description suivante de l'invention faite à titre non limitatif en relation avec les figures jointes parmi lesquelles :
- la figure 1 représente schématiquement l'architecture d'une mémoire selon la présente invention ;
- la figure 2 représente un circuit de la mémoire représentée sur la figure 1 ;
- la figure 3 est un organigramme illustrant le procédé selon l'invention ;
- la figure 4A est un chronogramme illustrant un cycle de lecture d'une mémoire classique ;
- la figure 4B est un chronogramme illustrant un cycle de lecture de la mémoire selon l'invention.

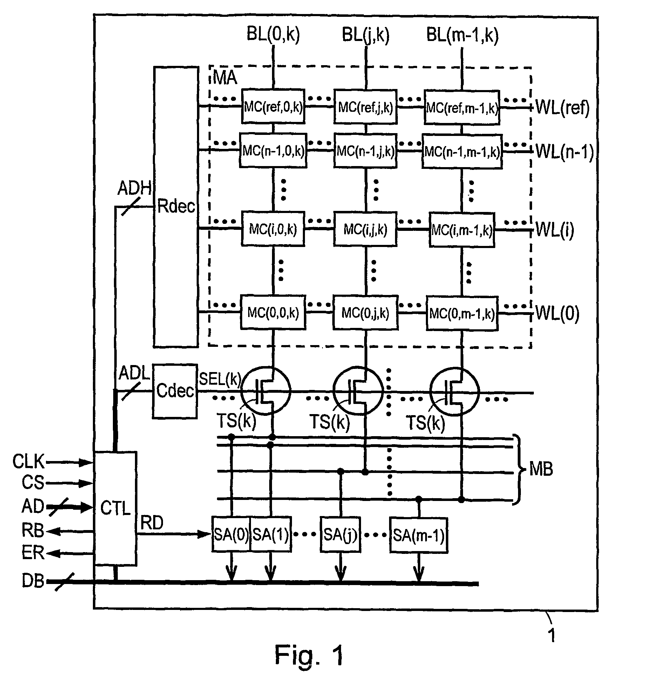

La figure 1 représente une mémoire 1 comprenant un plan mémoire MA, un décodeur de ligne de mot RDEC, un décodeur de colonne CDEC, et un circuit de contrôle CTL. Le plan mémoire MA comprend des cellules mémoire MC(i,j,k) connectées à des lignes de mot WL(i) disposées en rangées, et à des lignes de bit BL(j,k) disposées en colonnes. Les lignes de mot WL(i) sont contrôlées par le décodeur de ligne RDEC. Chaque ligne de bit BL(j,k) est reliée à un amplificateur de lecture SA(j) (j étant un nombre entier compris entre 0 et m-1) par l'intermédiaire d'un transistor de sélection TS(k) de colonne de mot de rang k, et d'un bus de multiplexage MB.

Les transistors de sélection TS(k) sont pilotés par un signal SEL(k) émis par le décodeur de colonne CDEC. Les amplificateurs de lecture SA(j) qui sont connectés en entrée au bus de multiplexage MB et en sortie à un bus DB de sortie de la mémoire, permettent de lire m bits d'un mot sélectionné dans une ligne de mot WL(i), et d'appliquer les valeurs de ces bits sur une ligne respective du bus DB.

Le circuit de contrôle CTL reçoit en entrée une adresse AD de lecture, ainsi que des signaux d'horloge CLK et de sélection de circuit CS (Chip Select) permettant d'activer la mémoire, et délivre en sortie un signal RD de déclenchement des amplificateurs de lecture, et des adresses ADH et ADL qui sont appliquées respectivement au décodeur de ligne RDEC et au décodeur de colonne CDEC. Typiquement, l'adresse ADH appliquée au décodeur de ligne regroupe les bits de poids fort de l'adresse AD appliquée en entrée de la mémoire, et l'adresse ADL appliquée au décodeur de colonne les bits de poids faible. A partir des adresses ADH et ADL, les décodeurs de ligne et de colonne sélectionnent une ligne de mot de rang i et une colonne de mot de rang k regroupant plusieurs lignes de bits BL(j,k). Le circuit de contrôle délivre en sortie de la mémoire un signal RB (Ready / Busy) permettant d'indiquer aux circuits extérieurs, si la mémoire est occupée ou prête à recevoir un nouvel ordre de lecture.

Selon l'invention, un groupe de cellules mémoire MC(ref,j,k) connectées à une ligne de mot WL(ref) du plan mémoire MA est réservée au stockage d'un mot de référence qui est lu à chaque phase de lecture d'un mot dans la mémoire. Le circuit de contrôle CTL est conçu pour récupérer le mot de référence lu et pour le comparer à une valeur attendue mémorisée par le circuit de contrôle. Si le mot de référence lu n'a pas la valeur attendue, le circuit de contrôle place la mémoire en mode d'erreur, par exemple en émettant un signal d'erreur sur une sortie ER de la mémoire prévue à cet effet.

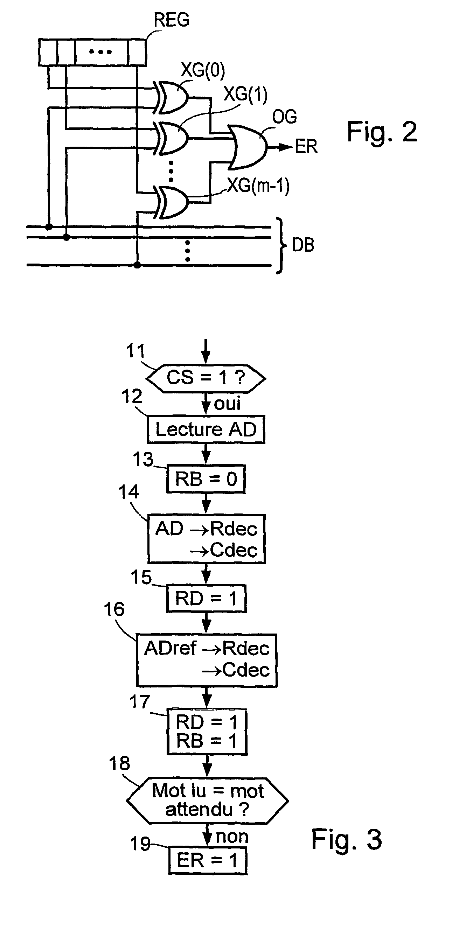

La figure 2 représente un exemple de réalisation d'un circuit de comparaison permettant d'effectuer une comparaison bit à bit entre le mot de référence lu, figurant sur le bus de donnée DB, et une valeur de référence par exemple mémorisée dans un registre REG interne au circuit de contrôle CTL. Le circuit de comparaison est conçu pour produire sur une sortie ER un signal à 1 si une différence sur au moins un bit est détectée entre le mot de référence lu et la valeur attendue de ce mot de référence. A cet effet, le circuit de comparaison comprend un ensemble de portes OU Exclusif XG(j) (j étant un nombre entier compris entre 0 et m-1). Chaque porte XG(j) comprend une première entrée connectée à une cellule respective du registre REG et une seconde entrée connectée à une ligne respective correspondante du bus DB. La sortie de chacune des portes XG(j) est connectée à une entrée respective d'une porte OU OG dont la sortie est connectée à la sortie ER du circuit de comparaison. Si tous les bits du registre contenant la valeur de référence sont identiques aux bits respectifs du mot de référence lu dans la ligne de mot WL(ref) figurant sur le bus DB, les sorties des portes XG(j) sont à 0. La sortie ER de la porte OU OG est également à 0. Par contre, si au moins l'un des bits du registre REG est différent du bit lu sur la ligne correspondante du bus de donnée DB, la porte XG(j) correspondante délivre un signal à 1, et la sortie ER de la porte OU OG passe à 1.

De préférence, la ligne de mot WL(ref) choisie pour mémoriser le mot de référence est située dans le plan mémoire MA à l'opposé du point de connexion des amplificateurs de lecture SA(j) aux lignes de bit BL(j,k). De cette manière, quelle que soit la zone du chemin de lecture où est appliquée la perturbation, la donnée de référence lue subira également la perturbation et sera donc différente de la valeur attendue.

La figure 3 illustre le procédé selon l'invention mis en oeuvre dans le circuit de contrôle CTL. Le procédé est activé lorsque le signal CS appliqué à la mémoire passe à 1 (étape 11). La levée de ce signal déclenche une phase de lecture d'une donnée dans la mémoire à l'adresse fournie sur le bus AD d'entrée d'adresse de la mémoire (étape 12). Simultanément, le circuit de contrôle place la mémoire à l'état occupé en levant le signal RB (étape 13).

A l'étape 14 suivante, le circuit de contrôle envoie les adresses ADH et ADL correspondant à l'adresse reçue sur le bus d'adresse AD aux décodeurs de ligne RDEC et de colonne CDEC, ce qui a pour effet de sélectionner les cellules mémoire MC(i,j,k) appartenant à une ligne de mot WL (i) et au groupe de ligne de bit BL (j, k) d'une colonne de mot de rang k.

A l'étape suivante 15, le circuit de contrôle lève un signal RD de déclenchement de la lecture qui est appliqué aux amplificateurs de lecture SA(j). Le mot lu est alors appliqué sur le bus de donnée DB par les amplificateurs de lecture SA(j). A la suite de la lecture d'un mot dans la mémoire, le circuit de contrôle envoie au décodeur de ligne RDEC, l'adresse du mot de référence stocké par la mémoire (étape 16).

La colonne de mot de rang k sélectionnée pour accéder au mot de référence est de préférence celle qui a été sélectionnée à l'étape 14 pour pouvoir détecter une perturbation quelle que soit la ligne de bit BL(j,k) du chemin de lecture de la donnée, où elle a été appliquée. Dans ce cas, tous les mots stockés dans les cellules mémoire de la ligne de mot de référence WL(ref) sont identiques et présentent la valeur stockée dans le registre REG.

A l'étape 17 suivante, le signal RD de déclenchement de lecture est à nouveau levé. Les amplificateurs de lecture appliquent alors la donnée de référence lue sur le bus de donnée. A l'étape 18 suivante, le circuit de contrôle compare le mot de référence lu avec la valeur de référence mémorisée dans le registre REG, et si une différence est détectée, le circuit de contrôle CTL met à 1 le signal appliqué sur la sortie ER de signal d'erreur.

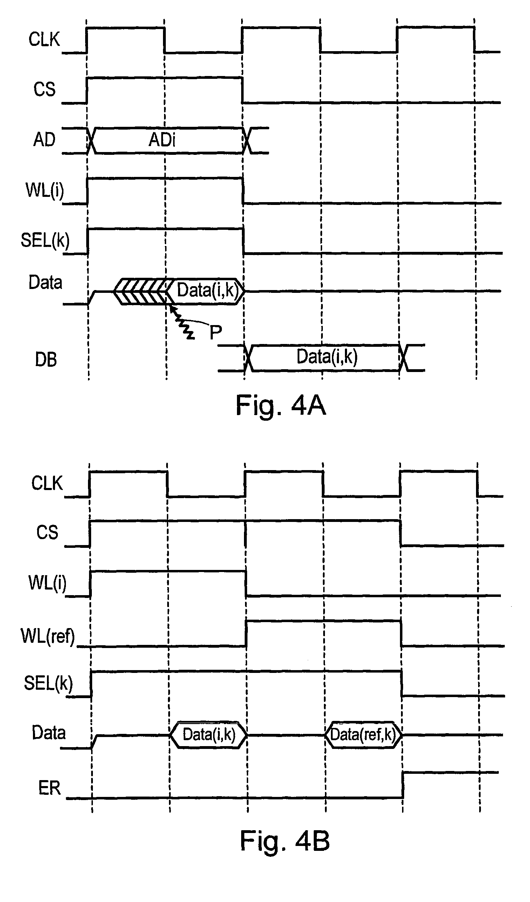

La figure 4A illustre sous la forme de chronogrammes une séquence classique de lecture d'un mot situé sur la ligne de mot WL(i) et dans la colonne de mot de rang k de la mémoire. Cette figure montre le signal d'horloge CLK, le signal CS d'activation de la mémoire, les signaux d'adresse AD, le signal WL(i) de sélection de ligne de mot, le signal SEL(k) de sélection de la colonne de mot de rang k, le signal Data de la donnée lue en sortie des amplificateurs de lecture SA(j), et le signal de donnée sur le bus DB.

Pendant un cycle d'horloge CLK, le signal CS d'activation de la mémoire est à 1, tandis que l'adresse de lecture est présente sur le bus AD. L'adresse de lecture est traitée par les décodeurs de ligne RDEC et de colonne CDEC pour déterminer quels sont les signaux WL(i) et SEL(k) de sélection de la ligne et de la colonne de mot à passer à 1 durant le même cycle d'horloge. Dès que les signaux WL(i) et SEL(k) passent à 1, les cellules mémoire correspondantes sont lues par les amplificateurs de lecture SA(j). Au cycle d'horloge suivant, la donnée lue Data(i,k) est transmise au bus de donnée DB. Si une perturbation P est appliquée au chemin de lecture, c'est-à-dire aux lignes de bit BL(j,k) ou aux amplificateurs de lecture, la donnée Data(i,k) transmise au bus de données DB est erronée.

Pour détecter une telle perturbation, les signaux CS de sélection de la mémoire et SEL(k) de sélection d'une colonne de mot de rang k sont maintenus à 1 durant deux cycles d'horloge, comme illustré sur la figure 4B. Comme dans la procédure de lecture classique (figure 4A), le signal WL(i) de sélection de la ligne de mot à lire est positionné à 1 pendant le premier cycle d'horloge. Durant le second cycle d'horloge, le signal WL(ref) de lecture de la ligne de mot de référence est placé à 1, pour lire le mot de référence Data(ref,k) stocké dans les cellules mémoire de la ligne WL(ref) et de la colonne de mot de rang k (signal SEL(k) à 1). Il en résulte qu'en sortie des amplificateurs de lecture SA(j), la donnée Data(i,k) apparaît à la fin du premier cycle d'horloge, et la donnée de référence Data(ref,k) lue dans la ligne de mot de référence apparaît à la fin du second cycle d'horloge. Si la valeur lue de la donnée de référence est différente de la valeur attendue, le signal d'erreur appliqué sur la sortie ER passe à 1.

Avantageusement, le circuit de contrôle CTL effectue la lecture de la donnée à lire et la lecture de la donnée de référence en un seul cycle du signal d'horloge CLK appliqué à la mémoire 1. A cet effet, le circuit de contrôle génère à partir du signal d'horloge CLK un signal d'horloge interne de séquencement des opérations de lecture dont la fréquence est égale au double de celle du signal d'horloge CLK.

Il apparaîtra clairement à l'homme de l'art que le procédé selon l'invention est susceptible de diverses variantes, notamment en ce qui concerne le traitement du signal d'erreur. Notamment, il n'est pas nécessaire que l'erreur soit signalée au milieu extérieur à la mémoire. Toute mesure appropriée peut ainsi être prise, comme l'effacement de données sensibles dans la mémoire. Si l'erreur est signalée au milieu extérieur, toute mesure appropriée peut être prise, comme l'initialisation de l'unité de traitement qui accède à la mémoire, ou la mise hors service définitive du circuit intégré incorporant la mémoire selon l'invention.

Par ailleurs, la lecture de la donnée de référence peut également être effectuée avant la lecture de la donnée correspondant à l'adresse appliquée sur le bus d'adresse de la mémoire.

En outre, l'invention est applicable à tout type de mémoire dans laquelle les cellules mémoire sont rangées en lignes et en colonnes, et dans laquelle une lecture est effectuée en sélectionnant une ligne et en lisant une ou simultanément plusieurs cellules mémoire de la ligne sélectionnée. Bien entendu, les notions de ligne et de colonne peuvent être inversées.

## Revendications

1. Procédé de lecture d'une donnée dans une mémoire (1), le procédé comportant un cycle de lecture d'une donnée (Data(i,k)) dans la mémoire, déclenché à la suite de la réception d'un ordre de lecture par la mémoire, et comprenant une étape de lecture de la donnée dans la mémoire,
**caractérisé en ce que** le cycle de lecture d'une donnée (Data(i,k)) comprend en outre des étapes consistant à :
- lire une donnée de référence (Data(ref,k)) stockée dans la mémoire,
- comparer la donnée de référence lue avec une valeur attendue (REG), et
- signaler une erreur de lecture si la donnée de référence lue est différente de la valeur attendue.

2. Procédé selon la revendication 1, dans lequel la lecture de la donnée de référence (Data(ref,k)) est effectuée immédiatement après la lecture de la donnée à lire dans la mémoire (1).

3. Procédé selon la revendication 1 ou 2, dans lequel la lecture de la donnée de référence est effectuée au cours d'un cycle d'horloge suivant la lecture de la donnée à lire dans la mémoire (1).

4. Procédé selon la revendication 1 ou 2, dans lequel la lecture de la donnée de référence est effectuée au cours d'un même cycle d'horloge que la lecture de la donnée à lire dans la mémoire (1).

5. Procédé selon l'une des revendications 1 à 4, dans lequel la donnée (Data(i,k)) est lue dans la mémoire
(1) en sélectionnant une ligne de mot (WL(i)) et une colonne de mot, la donnée de référence (Data(ref,k)) étant lue en sélectionnant la même colonne de mot (Sel(k)) et une ligne de mot de référence (WL(ref)).

6. Procédé selon l'une des revendications 1 à 5, dans lequel la mémoire (1) comprend des cellules mémoire (MC(i,j,k)) connectées à des lignes de mot (WL(i)) agencées en lignes, et à des lignes de bit (BL(j,k)) agencées en colonnes de bits, les lignes de mot étant connectées à un décodeur de ligne (RDEC), les lignes de bit étant reliées à des amplificateurs de lecture (SA(j)), la phase de lecture d'une donnée dans la mémoire comprenant des étapes consistant à :
- sélectionner une ligne de mot (WL(i)) correspondant à une adresse reçue de la donnée à lire,
- lire des cellules mémoires (MC(i,j,k)) de la ligne de mot sélectionnée,
- appliquer le contenu des cellules mémoire lues sur un bus de données (DB) de sortie de la mémoire,
- sélectionner une ligne de mot de référence (WL(ref)) correspondant à l'adresse de la donnée de référence,
- lire des cellules mémoire de référence (MC(ref,j,k)) de la ligne de mot de référence sélectionnée, dans lesquelles la donnée de référence (Data(ref,k)) est mémorisée,
- comparer la donnée de référence lue à une valeur attendue, et
- placer la mémoire dans un mode d'erreur si la donnée de référence lue est différente de la valeur attendue.

7. Procédé selon l'une des revendications 1 à 6, dans lequel la mémoire (1) émet un signal d'erreur (ER) en mode d'erreur.

8. Mémoire (1) sécurisée en lecture comprenant des moyens pour lire une donnée dans la mémoire durant un cycle de lecture, en réponse à une commande de lecture de la donnée reçue par la mémoire,
**caractérisée en ce qu'**elle comprend :
- des moyens pour lire dans la mémoire durant le cycle de lecture une donnée de référence, en réponse à la commande de lecture de la donnée ,
- des moyens (XG(j)) pour comparer la donnée de référence lue avec une valeur attendue (REG), et
- des moyens (OG) pour générer un signal d'erreur (ER) si la donnée de référence lue est différente de la valeur attendue.

9. Mémoire (1) selon la revendication 8, dans laquelle la lecture de la donnée et de la donnée de référence est effectuée durant un même cycle d'horloge.

10. Mémoire (1) selon la revendication 8, dans laquelle la lecture de la donnée et de la donnée de référence est effectuée durant deux cycles d'horloge successifs.

11. Mémoire (1) selon l'une des revendications 7 à 10, dans laquelle la donnée (Data(i,k)) est lue dans la mémoire (1) en sélectionnant une ligne de mot et une colonne de mot (Sel(k)), la donnée de référence (Data(ref,k)) étant lue en sélectionnant la même colonne de mot et une ligne de mot de référence (WL(ref)).

12. Mémoire (1) selon l'une des revendications 7 à 11, comprenant :
- des cellules mémoire (MC(i,j,k)) connectées à des lignes de mot (WL(i) agencées en lignes et à des lignes de bit (BL(j,k)) agencées en colonnes de bits,
- un décodeur de ligne (RDEC) connecté aux lignes de mot pour sélectionner une ligne de mot correspondant à une adresse reçue de la donnée à lire,
- des moyens (CTL) pour sélectionner durant le cycle de lecture d'un mot (Data(i,k)) dans la mémoire, une ligne de mot de référence (WL(ref)) à laquelle sont connectées des cellules mémoire de référence (MC(ref,j,k)) contenant la donnée de référence (Data(ref,k)), et pour déclencher la lecture des cellules mémoire de référence sélectionnées, et
- des moyens (XG(j)) pour comparer le contenu des cellules mémoire de référence lues à des valeurs attendues respectives, le signal d'erreur étant émis sur une sortie de signal d'erreur (ER) si le contenu d'une cellule mémoire de la ligne de mot de référence est différente d'une valeur attendue respective.

13. Mémoire (1) selon la revendication 12, dans laquelle les cellules mémoires sont disposées dans un plan mémoire (MA), la ligne de mot de référence (WL(ref)) étant située sur un bord du plan mémoire à l'opposé de liaisons des lignes de bit (BL(j,k)) avec des amplificateurs de lecture(SA(j)).

14. Mémoire (1) selon la revendication 12 ou 13, comprenant un décodeur de colonne (CDEC) pour sélectionner un groupe de lignes de bit (BL(j,k)) formant un mot correspondant à l'adresse reçue de la donnée à lire, les cellules mémoire (MC(ref,j,k)) de la ligne de mot de référence (WL(ref)) dans laquelle la donnée de référence (Data(ref,k)) est stockée, mémorisant la donnée de référence dans chaque groupe de lignes de bit.

## Claims

1. A method of reading a datum in a memory (1), the method comprising a read cycle of reading a datum (Data(i,k)) in the memory triggered following the receipt by the memory of a read order and comprising a step of reading the datum in the memory,
**characterized in that** the cycle of reading a datum (Data(i,k)) further comprises steps of:
- reading a reference datum (Data(ref,k)) stored in the memory,
- comparing the reference datum read with an expected value (REG), and
- signaling a read error if the reference datum read is different from the expected value.

2. Method according to claim 1, wherein the reference datum (Data(ref,k)) is read immediately after the reading of the datum to be read in the memory (1).

3. Method according to claim 1 or 2, wherein the reference datum is read during a clock cycle following the reading of the datum to be read in the memory (1).

4. Method according to claim 1 or 2, wherein the reference datum is read during a same clock cycle as the reading of the datum to be read in the memory (1).

5. Method according to one of claims 1 to 4, wherein the data (Data(i,k)) is read in the memory (1) by selecting a word line (WL(i)) and a word column, the reference datum (Data(ref,k)) being read by selecting the same word column (Sel(k)) and a reference word line (WL(ref)).

6. Method according to one of claims 1 to 5,
wherein the memory (1) comprises memory cells (MC(i,j,k)) connected to word lines (WL(i)) arranged in rows, and to bit lines (BL(j,k)) arranged in columns of bits, the word lines being connected to a row decoder (RDEC), the bit lines being linked to sense amplifiers (SA(j)), the phase of reading a datum in the memory comprising steps of:
- selecting a word line (WL(i)) corresponding to a received address of the datum to be read,
- reading memory cells (MC(i,j,k)) of the selected word line,
- applying the content of the memory cells read to an output data bus (DB) of the memory,
- selecting a reference word line (WL(ref)) corresponding to the address of the reference datum,
- reading reference memory cells (MC(ref,j,k)) of the selected reference word line, memory cells in which the reference datum (Data(ref,k)) is saved,
- comparing the reference datum read with an expected value, and
- putting the memory into an error mode if the reference datum read is different from the expected value.

7. Method according to one of claims 1 to 6, wherein the memory (1) sends an error signal (ER) in error mode.

8. A read-secured memory (1) comprising means for reading a datum in the memory during a read cycle, in response to a command for reading the datum received by the memory,
**characterized in that** it comprises:
- means for reading a reference datum in the memory during the read cycle, in response to the command for reading the datum,
- means (XG(j)) for comparing the reference datum read with an expected value (REG), and
- means (OG) for generating an error signal (ER) if the reference datum read is different from the expected value.

9. The memory (1) according to claim 8, wherein the datum and the reference datum are read during a same clock cycle.

10. The memory (1) according to claim 8, wherein the datum and the reference datum are read during two successive clock cycles.

11. The memory (1) according to one of claims 7 to 10,
wherein the datum (Data(i,k)) is read in the memory (1) by selecting a word line and a word column (Sel(k)), the reference datum (Data(ref,k)) being read by selecting the same word column and a reference word line (WL(ref)).

12. The memory (1) according to one of claims 7 to 11, comprising:
- memory cells (MC(i,j,k)) connected to word lines (WL(i)) arranged in rows and to bit lines (BL(j,k)) arranged in columns of bits,
- a row decoder (RDEC) connected to the word lines for selecting a word line corresponding to a received address of the datum to be read,
- means (CTL) for selecting, during the cycle of reading a word (Data(i,k)) in the memory, a reference word line (WL(ref)) to which reference memory cells (MC(ref,j,k)) containing the reference datum (Data(ref,k)) are connected, and for triggering the reading of the selected reference memory cells, and
- means (XG(j)) for comparing the content of the reference memory cells read with respective expected values, the error signal being sent on an error signal output (ER) if the content of a memory cell of the reference word line is different from a respective expected value.

13. The memory (1) according to claim 12, wherein the memory cells are disposed in a memory array (MA), the reference word line (WL(ref)) being located on one edge of the memory array opposite links between the bit lines (BL(j,k)) and sense amplifiers (SA(j)).

14. The memory (1) according to claim 12 or 13, comprising a column decoder (CDEC) for selecting a group of bit lines (BL(j,k)) forming a word corresponding to the received address of the datum to be read, the memory cells (MC(ref,j,k)) of the reference word line (WL(ref)) in which the reference datum (Data(ref,k)) is stored saving the reference datum in each group of bit lines.

## Patentansprüche

1. Verfahren zum Lesen eines Datenwertes in einem Speicher (1), wobei das Verfahren einen Zyklus des Lesens eines Datenwertes (Data (i,k)) im Speicher umfasst, der nach dem Empfang eines Lesebefehls durch den Speicher freigegeben wird, und einen Schritt des Lesens des Datenwertes im Speicher umfasst,
**dadurch gekennzeichnet, dass** der Zyklus des Lesens eines Datenwertes (Data (i,k)) ferner Schritte umfasst, die aus Folgendem bestehen:
- Lesen eines Referenzdatenwertes (Data (ref,k)), der im Speicher gespeichert ist,
- Vergleichen des gelesenen Referenzdatenwertes mit einem erwarteten Wert (REG), und
- Signalisieren eines Lesefehlers, wenn sich der gelesene Referenzdatenwert vom erwarteten Wert unterscheidet.

2. Verfahren nach Anspruch 1, wobei das Lesen des Referenzdatenwertes (Data (ref,k)) unmittelbar nach dem Lesen des im Speicher (1) zu lesenden Datenwertes ausgeführt wird.

3. Verfahren nach Anspruch 1 oder 2, wobei das Lesen des Referenzdatenwertes im Laufe eines Taktzyklus ausgeführt wird, der auf das Lesen des im Speicher (1) zu lesenden Datenwertes folgt.

4. Verfahren nach Anspruch 1 oder 2, wobei das Lesen des Referenzdatenwertes im Laufe desselben Taktzyklus wie das Lesen des im Speicher (1) zu lesenden Datenwertes ausgeführt wird.

5. Verfahren nach einem der Ansprüche 1 bis 4, wobei der Datenwert (Data (i,k)) im Speicher (1) gelesen wird, indem eine Wortzeile (WL(i)) und eine Wortspalte ausgewählt werden, wobei der Referenzdatenwert (Data(ref,k)) gelesen wird, indem die gleiche Wortspalte (Sel(k)) und eine Referenz-Wortzeile (WL(ref)) ausgewählt werden.

6. Verfahren nach einem der Ansprüche 1 bis 5, wobei der Speicher (1) Speicherzellen (MC(i,j,k)) umfasst, die mit Wortzeilen (WL(i)), die in Zeilen angeordnet sind, und mit Bitzeilen (BL(j,k)), die in Bitspalten angeordnet sind, verbunden sind, wobei die Wortzeilen mit einem Zeilendecoder (RDEC) verbunden sind, die Bitzeilen an Leseverstärker (SA(j)) angeschlossen sind und die Stufe des Lesens des Datenwertes im Speicher Schritte umfasst, die aus Folgendem bestehen:
- Auswählen einer Wortzeile (WL(i)), die einer empfangenen Adresse des zu lesenden Datenwertes entspricht,
- Lesen der Speicherzellen (MC(i,j,k)) der ausgewählten Wortzeile,
- Anlegen des Inhalts der gelesenen Speicherzellen an einen Ausgangs-Datenbus (DB) des Speichers,
- Auswählen einer Referenz-Wortzeile (WL(ref)), die der Adresse des Referenzdatenwertes entspricht,
- Lesen von Referenz-Speicherzellen (MC(ref,j,k)) der ausgewählten Referenz-Wortzeile, in denen der Referenzdatenwert (Data(ref,k) gespeichert ist,
- Vergleichen des gelesenen Referenzdatenwertes mit einem erwarteten Wert, und
- Versetzen des Speichers in einen Fehlermodus, wenn sich der gelesene Referenzdatenwert vom erwarteten Wert unterscheidet.

7. Verfahren nach einem der Ansprüche 1 bis 6, wobei der Speicher (1) im Fehlermodus ein Fehlersignal (ER) ausgibt.

8. Lesegesicherter Speicher (1), umfassend Mittel zum Lesen eines Datenwertes im Speicher während eines Lesezyklus als Reaktion auf einen Befehl zum Lesen des Datenwertes, der vom Speicher empfangen wird,
**dadurch gekennzeichnet, dass** er Folgendes umfasst:
- Mittel zum Lesen eines Referenzdatenwertes im Speicher während des Lesezyklus als Reaktion auf den Befehl zum Lesen des Datenwertes,
- Mittel (XG(j)) zum Vergleichen des gelesenen Referenzdatenwertes mit einem erwarteten Wert (REG), und
- Mittel (OG) zum Erzeugen eines Fehlersignals (ER), wenn der gelesene Referenzdatenwert sich vom erwarteten Wert unterscheidet.

9. Speicher (1) nach Anspruch 8, wobei das Lesen des Datenwertes und des Referenzdatenwertes während desselben Taktzyklus ausgeführt wird.

10. Speicher (1) nach Anspruch 8, wobei das Lesen des Datenwertes und des Referenzdatenwertes während zwei aufeinander folgender Taktzyklen ausgeführt wird.

11. Speicher (1) nach einem der Ansprüche 7 bis 10, wobei die Daten (Data (i,k)) im Speicher (1) gelesen werden, indem eine Wortzeile (WL(i)) und eine Wortspalte (Sel(k)) ausgewählt werden, wobei die Referenzdaten (Data(ref,k)) gelesen werden, indem die gleiche Wortspalte und eine Referenz-Wortzeile (WL(ref)) ausgewählt werden.

12. Speicher (1) nach einem der Ansprüche 7 bis 11, umfassend:
- Speicherzellen (MC(i,j,k)), die mit Wortzeilen (WL(i)), die in Zeilen angeordnet sind, und mit Bitzeilen (BL(j,k)), die in Bitspalten angeordnet sind, verbunden sind,
- einen Zeilendecoder (RDEC), der mit den Wortzeilen verbunden ist, um eine Wortzeile auszuwählen, die einer empfangenen Adresse des zu lesenden Datenwertes entspricht,
- Mittel (CTL) zum Auswählen einer Referenz-Wortzeile (WL(ref)), mit der Referenz-Speicherzellen (MC(ref,j,k)) verbunden sind, welche den Referenzdatenwert (Data(ref,k)) enthalten, während des Zyklus des Lesens eines Worts (Data(i,k)) im Speicher und zum Freigeben des Lesens der ausgewählten Referenz-Speicherzellen, und
- Mittel (XG(j)) zum Vergleichen des Inhalts der gelesenen Referenz-Speicherzellen mit jeweiligen erwarteten Werten, wobei das Fehlersignal (ER) an einem Fehlersignalausgang ausgegeben wird, wenn sich der Inhalt einer Speicherzelle der Referenz-Wortzeile von einem jeweiligen erwarteten Wert unterscheidet.

13. Speicher (1) nach Anspruch 12, wobei die Speicherzellen in einem Speicherfeld (MA) angeordnet sind, wobei die Referenz-Wortzeile (WL(ref)) an einem Rand des Speicherfelds angeordnet ist, der den Verbindungen der Bitleitungen (BL(j,k)) mit Leseverstärkern (SA(j)) gegenüberliegt.

14. Speicher (1) nach Anspruch 12 oder 13, umfassend einen Spaltendecoder (CDEC) zum Auswählen einer Gruppe von Bitzeilen (BL(j,k)), die ein Wort bilden, das der empfangenen Adresse des zu lesenden Datenwertes entspricht, wobei die Speicherzellen (MC(ref,j,k)) der Referenz-Wortzeile (WL(ref)), in der der Referenzdatenwert (Data(ref,k)) gespeichert ist, den Referenzdatenwert einer jeden Gruppe an Bitzeilen speichert.
